# EUROPEAN PATENT APPLICATION

(11) **EP 2 282 403 A2**
(43) Date of publication of application: **09.02.2011**
(21) Application number: 10182777.2
(22) Date of filing: 06.12.2006
(51) Int. Cl.: H03G 3/30

(54) **Portable audio device providing automated control of audio volume parameters for hearing protection**

(30) Priority: 07.12.2005 US 297032
(62) Divisional of application: 06256215.2
(71) Applicant: Apple Inc., Cupertino, CA 95014 (US)
(72) Inventor: Lee, Michael M, San Jose, CA 95130 (US); Arthur, John Eric, Santa Clara, CA 95051 (US); Marriott, Greg, Honolulu, HI 96825 (US)
(74) Representative: Gillard, Matthew Paul

(57) **Abstract**

A method of operating a media player includes playing back audio media. During the step of playing back audio media, a maximum volume parameter is refined for the playing back of the media by the media player. The refining is based at least in part on the playing back of audio media during a time period prior to executing the maximum volume refining step. After a period of time, the maximum volume refining step is repeated. The refining is configured to prevent/minimize harm to hearing of the media player user based, for example, on the actual volume of media playback and time/duration profiles provided by occupational safety and/or other organizations.

## Description

### BACKGROUND

Portable media players are becoming pervasive, particularly among relatively younger people. An unintended side effect of using such players is the damaging effect on the users' hearing. The damaging effect on the users' hearing may be exacerbated by new manners of use (all day use, versus for limited time periods such as during jogging) and, perhaps, by the configuration of the headphones (in the ear).

Furthermore, since the damaging effect on users' hearing is both gradual and cumulative, even those users who are concerned about hearing loss may not behave with respect to their portable media players in a manner that would limit or minimize such damaging hearing effects.

### SUMMARY

A method of operating a media player includes playing back audio media. During the step of playing back audio media, a maximum volume parameter is refined for the playing back of the media by the media player. The refining is based at least in part on the playing back of audio media during a time period prior to executing the maximum volume refining step. After a period of time, the maximum volume refining step is repeated.

The refining is configured to prevent/minimize harm to hearing of the media player user based, for example, on the actual volume of media playback and time/duration profiles provided by occupational safety and/or other organizations.

### BRIEF DESCRIPTION OF THE DRAWINGS

By way of example only, certain embodiments of the invention will now be described by reference to the accomopanying drawings, in which:

Fig. 1 illustrates a host application in detachable communication with a portable media player, including communication of an indication of protection parameters from the host application to the portable media player;

Fig. 2 is a flowchart illustrating processing in the portable media player for refining a maximum volume value based on an actual volume of media playback by the portable media player;

Fig. 3 illustrates a table of compensation factors, based on headphone type, employed in refining the maximum volume value; and

Fig. 4 illustrates a table of compensation factors, based on song characteristics, employed in refining the maximum volume value.

### DETAILED DESCRIPTION

In accordance with a broad aspect, a portable media player processes protection parameters to control the playback of media by the portable media player. During use of the portable media player and based on actual use of the portable media player, the protection parameters are adjusted. Thus, for example, the adjustment of the protection parameters may take into account volume of playback in actual use, including duration of playback.

In one example, a "credit" accounting is maintained for determining the protection parameters, where credits are subtracted based on actual use that has first particular characteristics, whereas credits are added based on actual use that has second particular characteristics. For example, the first particular characteristics may be characteristics for which it has been determined to have a relatively damaging cumulative effect on hearing (e.g., relatively "loud" playback), whereas the second particular characteristics may be characteristics for which it has been determined to not have a relatively damaging cumulative effect on hearing (e.g., relatively "soft" playback, that allows recovery from the relatively damaging cumulative effect on hearing).

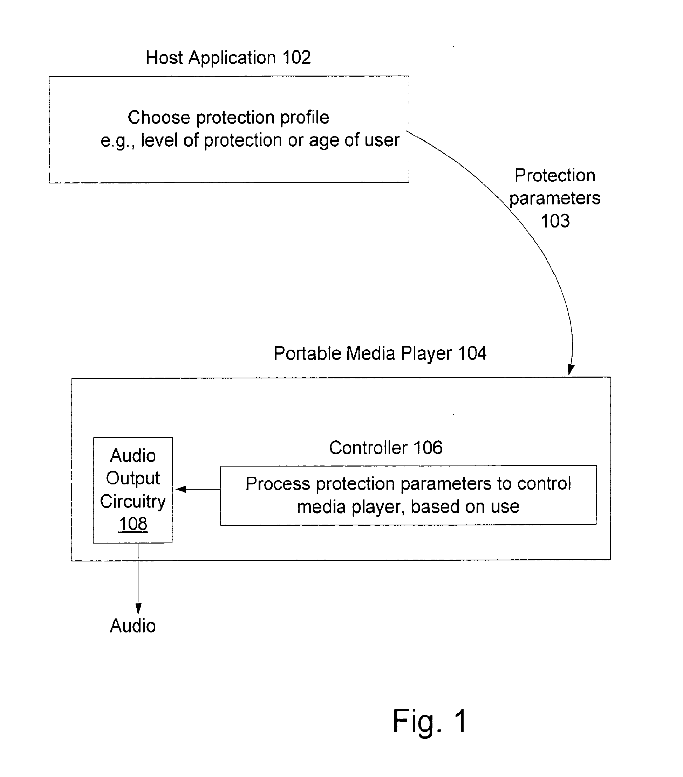

Fig. 1 broadly illustrates one example of an architecture that uses protection parameters. As shown in Fig. 1, a host application 102 executing on a computer interfaces with a portable media player 104. The host application 102 may be, for example, the iTunes ® software provided by Apple Computer, Inc. In one example, a user (e.g., a parent of the user of the portable media player 104) interacts with the host application 102 to choose a protection profile. The protection profile may be based, for example, on a desired level of protection (such as "low," "medium" and "high") or on an age of the user (e.g., assuming that a younger user requires more constraints).

As also shown in Fig. 1, an indication of protection parameters is provided from the host application 102 to the portable media player 104. The protection parameters may be prestored on the portable media player 104, with a signal being provided to from the host application 102 to the portable media player 104 that indicates which protection parameters to use. In other examples, a user of the portable media player 104 interacts directly with the portable media player 104 to cause the protection parameters to be indicated. Indication of the protection parameters may also be a result of interaction with both the host application 102 and the portable media player 104.

In the portable media player 104, a controller 106 processes the protection parameters to determine threshold playback characteristics, such as maximum playback volume or characteristics that are an indication of (and/or contribute to) the maximum playback volume. The actual playback by the portable media player, by audio output circuitry 108, is thus constrained by the determined threshold playback characteristics. Moreover, the threshold playback characteristics are adjusted by the controller based on characteristics of the actual playback operation of the portable media player 104. In some examples, the threshold playback characteristics are determined on the host, by the host application 102.

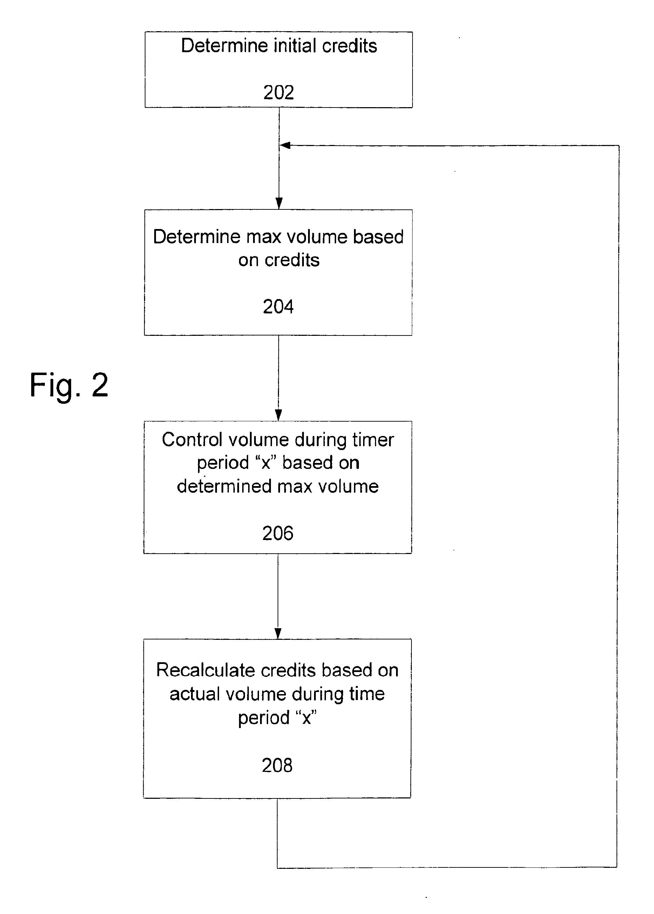

Fig. 2 is a flowchart illustrating an example of processing within the controller 106 of the portable media player 104 (Fig. 1) to accomplish enforcing the protection parameters. The controller may operate, for example, in a programmed manner based on software or firmware instructions. However, the controller is not limited, for example, to being a processor that executes instructions. In the Fig. 2 example, a "credit" scheme is employed. It is noted that this is an example, and other types of schemes may be employed. Turning now specifically to Fig. 2, at step 202, an initial number of credits is determined based on the protection parameters indicated or provided by the host application 102.

At step 204, a maximum allowed volume parameter, indicative of a maximum volume allowed for the next timer period "x" is determined based on the determined credits. In one particular example, the maximum allowed volume is determined based on the determined credits with reference to a profile such as profiles provided by the California Occupational Safety and Health Administration (Cal-OSHA). See, for example, Cal-OSHA Regulations - Control of Noise Exposures, in the California Code of Regulations, Title 8, Section 5096-5100 Article 105 and, see also, Permissible Noise Exposure - Table N-1 of the just-referenced regulation. It is noted that the profiles promulgated by Cal-OSHA appear to be rudimentary (e.g., do not deal in a sophisticated way with varying exposure over time and do not deal account for "recovery"). Thus, in some examples, more sophisticated profiles are employed.

At step 206, during the time period "x", the actual volume is controlled based on the determined maximum volume for the time period "x." Details according to particular examples are discussed later.

At step 208, the credits are recalculated based on the actual volume during the timer period "x." For example, if the user of the portable media player set the desired volume to be less than the determined maximum volume (or, perhaps, less than some other volume that is less than the determined maximum volume), then this may have allowed the user's hearing some "recovery" such that credits can be granted. That is, the credits may be usable to increase the determined maximum volume (as determined at step 204) for a future time period "x." After the credits are recalculated, then processing returns to step 204 for the next time period "x."

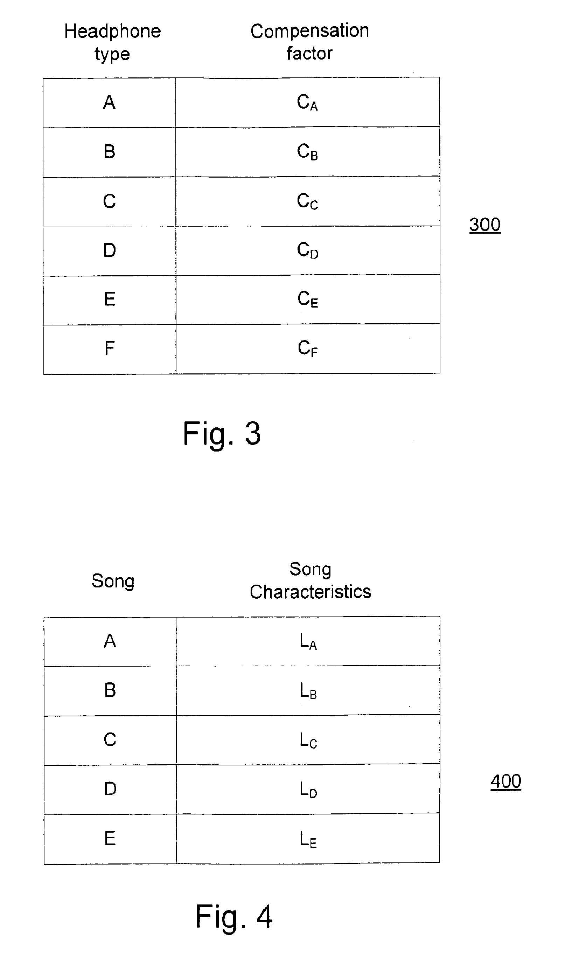

We now discuss, with reference to Figs. 3 and 4, how step 204 processing may be affected by factors other than those purely within the profiles. Fig. 3 is an example of compensation factors that are utilized for various types of headphones. That is, the compensation factors may be factors that indicate (and, thus, are used as parameters to the formulas) how the formula may be modified for a particular headphone such that the formula more accurately reflects reality. For example, for a particular volume of sound output, one headphone may have characteristics versus characteristics of another headphone such that the first headphone does not have as deleterious effect on hearing as does the second headphone, even at the same particular volume of sound output. In various examples, compensation factors are provided for general types of headphones (e.g., earbud, over the ear, etc.) and, in other examples, the compensation factors are more specific, provided for various models of headphones.

Fig. 4 illustrates another example of compensation factor. In particular, Fig. 4 illustrates providing a compensation factor that characterizes the media that is being played. In one example, the characteristic is a characteristic (or is based on a characteristic) that has been determined by a Soundcheck feature of iTunes, indicating an approximate audio level of the song.

We now discuss details of an example of controlling the volume during time period "x" based on the determined maximum volume. In one example, the determined maximum volume is treated as a threshold. Thus, if the user of the portable media player sets the volume to a desired volume that is greater than the determined maximum volume for the time period "x," then the actual playback volume is set to the determined maximum volume. On the other hand, if the user of the portable media player sets the volume to a desired volume that is less than the determined maximum volume for the timer period "x," then the actual playback volume is set to the desired volume.

In another example, the indication of the determined maximum volume parameter is used in step 206 as a scale factor, such that the actual volume of audio output is the desired volume, scaled down by the scale factor.

In addition to lowering of the volume in step 206 leading to additional credits in step 208, a complete cessation of playing the media player should also lead to additional credits upon restarting of playing. Thus, in one example, when audio output is stopped, the time of cessation is stored such that, upon restarting of playing, the time between cessation and restarting can be treated as a "quiet" time during which recovery has taken place and for which credits should be added.

In other examples, at step 204, the determined maximum volume may be either zero or "indeterminate" (i.e., whatever volume the user desires). In these examples, then, the processing at step 206 operates to control the volume only when the determine maximum volume is zero - shutting down the audio output of the media player. At step 208, as part of the recalculating step, a user interface function may be provided to give the user of the portable media player an indication of how many credits remain. This indication may be, for example, an indication of how long output will be allowed at the current actual volume, based on the remaining credits. The indication may be a simple binary indication (such as flashing when only a threshold amount of time remains).

In some examples, causing the indication of the protection parameters is secure such that, for example, a parent could securely set the protection parameters for a child user of the portable media player. In one example, the host software 102 is used to create a tamperproof (or tamper-resistant) configuration file as described, for example, in United States Patent Application No. 11/191,133, entitled CONFIGURATION OF A COMPUTING DEVICE IN A SECURE MANNER, filed on July 26, 2005 (the disclosure of which is incorporated herein in its entirety).

Furthermore, the discussion thus far has been in the context of a portable media player. However, in some examples, the concepts discussed herein are also applicable to audio devices such as, for example, cellular phones. With some audio devices, the audio playback characteristics can not (or, at least, cannot primarily) be determined in advance. For example, while playback characteristics of a song can be determined in advance (as illustrated by Fig. 4, for example), the levels of a voice speaking over a cellular phone connection typically cannot be determined in advance. Thus, in such situations, recalculating the credits (or otherwise adjusting how volume is to be controlled) may be more complicated, since more sophisticated monitoring of actual volume may be required.

While this invention has been described in terms of several embodiments, there are alterations, permutations, and equivalents, which fall within the scope of this invention. It should also be noted that there are many alternative ways of implementing the methods and apparatuses of the present invention. It is therefore intended that the following appended claims be interpreted as including all such alterations, permutations, and equivalents as fall within the true spirit and scope of the present invention.

Before going on to set out the claims however, we first provide the following list of clauses, which point out some features of some embodiments of the invention:
*1. A method of operating a portable audio device, comprising:*
   *playing audio; and*
   *during the step of playing audio,*
   *refining a maximum volume parameter for the playing the audio by the portable audio device, based at least in part on the playing of audio during a time period prior to executing the maximum volume refining step; and*
   *after a period of time, repeating the maximum volume refining step.*
*2. The method of clause 1, wherein:*
   *the refining step is further based on a predetermined formula of duration*/*volume hearing safety characteristics.*
*3. The method of clause 2, wherein:*
   *the duration versus volume characteristics account for increasing maximum allowed volume based on recovery.*
*4. The method of clause 2 or 3, further comprising:*
   *configuring the portable audio device to utilize the predetermined formula of duration*/*volume hearing safety characteristics.*
*5. The method of clause 4, wherein:*
   *the step of configuring the portable audio device to utilize the predetermined formula of duration*/*volume hearing safety characteristics includes interacting with a host computer that is in detachable communication with the portable audio device.*
*6. The method of any of clauses 1-5, wherein:*
   *the refining step is further based on audio production characteristics of the portable audio device.*
*7. The method of clause 6, wherein the audio production characteristics of the portable audio device include a property of headphones connected to the portable audio device.*
*8. The method of any of clauses 1-7, wherein:*
   *the refining step is further based on audio properties of the audio being played.*
*9. The method of clause 8, further comprising:*
   *providing an indication of the audio properties to the portable audio device from a host computer to which the portable audio device is detachably coupled.*
*10. The method of any of clauses 1-9, wherein:*
   *if the refined maximum volume is lower than a predetermined threshold volume, providing an indication thereof to the user of the portable audio device.*
*11. The method of any of clauses 1-9, wherein:*
   *if the refined maximum volume is zero, stopping the audio playing step.*
*12. The method of any of clauses 1-9, wherein:*
   *if the refined maximum volume is above a desired volume indicated by a user of the portable audio device, limiting the actual volume of audio playing based on the refined maximum volume.*
*13. A portable audio device, comprising:*
   *audio output circuitry via which audio signals are provided corresponding to playing of audio; and*
   *a controller coupled to control the audio output circuitry, the controller configured to, during palying of audio,*
   *refine a maximum volume parameter, for providing the audio signals corresponding to the playing of audio, the refining based at least in part on the providing of audio signals during a time period prior to refining the maximum volume; and*
   *after a period of time, repeating the maximum volume refining.*
*14. The portable audio device of clause 13, wherein:*
   *the refining is further based on a predetermined formula of duration*/*volume hearing safety characteristics.*
*15. The portable audio device of clause 14, wherein:*
   *the duration versus volume characteristics account for increasing maximum allowed volume based on recovery.*
*16. The portable audio device of clause 14 or 15, wherein the controller is further configured to utilize the predetermined formula of duration*/*volume hearing safety characteristics.*
*17. The portable audio device of clause 16, wherein:*
   *the controller being configured to utilize the predetermined formula of duration*/*volume hearing safety characteristics includes the controller being configured to interact with a host computer that is in detachable communication with the media player.*
*18. The portable audio device of any of clauses 13-17, wherein:*
   *the refining is further based on audio production characteristics of audio output circuitry.*
*19. The portable audio device of clause 18, wherein:*
   *the audio production characteristics of the audio output circuitry include a property of headphones connected to the portable audio device.*
*20. The portable audio device of any of clauses 13-19, wherein:*
   *the refining is further based on audio properties of the audio being played.*
*21. The portable audio device of clause 20, wherein the controller is further configured to cause an indication of the audio properties to be provided to the portable audio device from a host computer to which the portable audio device is detachably coupled.*
*22. The portable audio device of any of clauses 13-21, wherein the controller is configured such that:*
   *if the refined maximum volume is lower than a predetermined threshold volume, an indication thereof is caused to be provided to the user of the portable audio device.*
*23. The portable audio device of any of clauses 13-21, wherein the controller is configured such that, if the refined maximum volume is zero, playing back the audio is caused to be stopped.*
*24. The portable audio device of any of clauses 13-21, wherein the controller is configured such that, if the refined maximum volume is above a desired volume indicated by a user of the portable audio device, the actual volume of audio corresponding to playing the audio is caused to be based on the refined maximum volume.*
*25. A method of configuring a portable audio device, comprising:*
   *indicating hearing protection parameters to the portable audio device; and*
   *by a controller of the portable audio device, controlling audio output levels of audio output circuitry of the portable audio device based on processing the indicated hearing protection parameters.*
*26. The method of clause 25, wherein:*
   *the hearing protection parameters are indicated to the portable audio device as a result of interaction between the portable audio device and a host application executing on a host computer to which the portable audio device is attached.*
*27. The method of clause 25, wherein:*
   *the hearing protection parameters are indicated to the portable audio device as a result of user interaction directly with the portable audio device.*
*28. The method of clause 25, wherein:*
   *the controller processes the hearing protection parameters to determine threshold audio output characteristics, and*
   *the audio output levels of the audio output circuitry are controlled at least in part according to the determined threshold audio output characteristics.*
*29. The method of clause 28, further comprising:*
   *adjusting the threshold audio output characteristics based on characteristics of actual audio output of the audio output circuitry.*
*30. The method of clause 16, wherein:*
   *the audio output levels of the audio output circuitry of the portable audio device being controlled at least in part according to the indicated hearing protection parameters includes adjusting the audio output levels of the audio output circuitry based on an actual audio output level of the audio output circuitry.*
*31. The method of clause 16, wherein:*
   *the indicated hearing parameters are stored within the portable audio device in at least a tamper resistant manner.*
*32. The method of clause 16, wherein:*
   *the indicated hearing protection parameters are indicative of a hearing protection profile.*
*33. The method of clause 32, further comprising:*
   *adjusting the audio output levels of the audio output circuitry based on characteristics of an actual audio output level of the audio output circuitry relative to the hearing protection profile.*
*34. A portable audio device, comprising:*
   *audio output circuitry configured to output audio signals; and*
   *a controller configured to control the audio output circuitry, the controller configured such that during output of audio signals by the audio output circuitry, an actual parameter relative to output of the audio signal is limited to be at least within a particular boundary parameter,*
   *wherein the particular boundary parameter is based at least on part on hearing protection parameters available to the controller.*
*35. The portable audio device of clause 34, wherein:*
   *the protection parameters are provided via a user interface directly to the portable audio device.*
*36. The portable audio device of clause 34, further comprising:*
   *a host computer coupled to the portable audio device, wherein the host computer is configured to provided the protection parameters.*
*37. The portable audio device of clause 36, wherein:*
   *the host computer is configured to provide protection parameters as indicated via a user interface to an application executing on the host computer.*
*38. The portable audio device of clause 34, wherein:*
   *the portable audio device is configured to adjust the boundary parameter based on the actual parameter relative to the hearing protection parameters.*

## Claims

1. A method for dynamically changing a maximum volume of a portable media device (104), comprising:
for a listening session,
determining a number of remaining volume credits on the portable media device (104) for a listening session, the number of remaining volume credits corresponding to a permissible duration of time to operate the portable media player at a current actual volume;
monitoring the current actual volume of the portable media device (104) over a period of time;
adjusting the number of volume credits based on the monitored current actual volume over a period of time; and
changing the maximum volume based on the number of remaining credits available.

2. The method of claim 1, wherein the number of volume credits available is initially determined based on a protection profile.

3. The method of claim 2, wherein the protection profile is stored on a host computer with which the portable media device (104) interacts.

4. The method of claims 2 or 3, wherein the protection profile is based on an age of a user.

5. The method of any one of claims 2 to 4, further comprising:
repeating the determining, monitoring, and adjusting such that the maximum volume is dynamically set based on available credits, and wherein if the number of credits available is non-zero, the maximum volume is set at a first level, and wherein if the number of credits available is zero, the maximum volume is set at a second level.

6. A portable media device (104) comprising:
a memory storing a plurality of media files;
an interface;
an audio output controller; and
a processor configured to:
for a listening session,
determine a number of remaining volume credits on the portable media device (104) for a listening session, the number of remaining volume credits corresponding to a permissible duration of time to operate the portable media device at a current actual volume;
monitor the current actual volume of the portable media device (104) over a period of time;
adjust the number of volume credits based on the monitored current actual volume over the period of time; and
change the maximum volume based on the number of credits available.

7. The portable media device (104) of claim 6, wherein the processor is further configured to:
monitor actual output volume through the audio output controller over a fixed period of time;
adjust the number of volume credits based on the actual output volume over the fixed period of time; and
operate the audio output controller to play audio output of one or more of the media files at a maximum volume of a first level for another fixed period of time if the number of volume credits exceeds zero, otherwise play the audio output of the one or more of the media files at a maximum volume of a second level lower than the first level for another fixed period of time.

8. The portable media device (104) of claims 6 or 7, wherein the audio output controller is connected to an external circuit.

9. The portable media device (104) of claim 8 wherein the external circuit is selected from a group comprising a headphone jack and a speaker.

10. The portable media device (104) of claim 6, wherein the portable media device (104) is a cellphone.

11. A program executable by a processor for operating a portable media device (104), the program comprising:
computer code for determining a number of remaining volume credits on the portable media device (104) for a listening session, the number of remaining volume credits corresponding to a permissible duration of time to operate the portable media device at a current actual volume;
computer code for monitoring the current actual volume of the portable media device (104) over a period of time;
computer code for adjusting the number of volume credits based on the monitored current actual volume over the period of time; and
computer code for changing the maximum volume based on the number of remaining credits available.

12. The program of claim 11, further comprising:
computer code for adding volume credits to the volume credits available when the portable media device (104) is not in use.

13. The program of claim 12, wherein the computer code for adjusting includes computer code for decreasing the number of volume credits at a higher rate the louder the actual volume of the portable media device (104).

14. The program of claim 11, wherein the actual volume of the portable media device (104) includes the playing of output through a headphone.
